# EUROPÄISCHE PATENTSCHRIFT

(11) **EP 2 831 601 B1**
(45) Veröffentlichungstag und Bekanntmachung des Hinweises auf die Patenterteilung: **13.01.2016**
(21) Anmeldenummer: 13705147.0
(22) Anmeldetag: 14.02.2013
(51) Int. Cl.: G01R 1/20

(54) **ELEKTRONISCHER BATTERIESENSOR**
ELECTRONIC BATTERY SENSOR
CAPTEUR DE BATTERIE ÉLECTRONIQUE

(30) Priorität: 27.03.2012 DE 102012204844
(43) Veröffentlichungstag der Anmeldung: 04.02.2015
(73) Patentinhaber: Robert Bosch GmbH, 70442 Stuttgart (DE)
(72) Erfinder: DOLLANSKY, Matthias, 71701 Schwieberdingen (DE); MAZINGUE-DESAILLY, Stephan, 71640 Ludwigsburg (DE); SCHIMMEL, Chris, 71332 Waiblingen (DE); MUELLER, Michael, 71277 Rutesheim (DE)
(86) Internationale Anmeldenummer: PCT/EP2013/052979
(87) Internationale Veröffentlichungsnummer: WO 2013/143768

(56) Entgegenhaltungen:
- US-A1- 2009 039 865

## Beschreibung

Die vorliegende Erfindung betrifft einen elektronischen Batteriesensor sowie einen Shuntwiderstand zum Einsatz in einem elektronischen Batteriesensor. Ferner wird ein entsprechendes Verfahren zur Bereitstellung eines elektronischen Batteriesensors bereitgestellt.

### Stand der Technik

Insbesondere im Winter zählen Ausfälle durch entladene oder vorzeitig gealterte Batterien nach wie vor zu den häufigsten Fehlerursachen. Eine immer größer werdende Anzahl von elektronischen Funktionen in einem Kraftfahrzeug, wie bspw. Sitz- oder Standheizung oder DVD-Player, und deren gleichzeitiger Betrieb erfordern ein gut entwickeltes Batterie- bzw. Energiemanagement. Ein wichtiger Teil eines derartigen Batteriemanagements ist ein elektronischer Batteriesensor, der in regelmäßigen Abständen Spannung, Stromstärke und Temperatur in der Nähe einer entsprechenden Kraftfahrzeugbatterie genau erfasst. Dabei werden die Daten, anders wie bei anderen Sensoren, nicht an ein Steuergerät weitergegeben, sondern von einem in dem Batteriesensor integrierten Steuergerät verarbeitet. Dadurch können ein Zustand einer Batterie erkannt und Fragen, bspw. "wie wird die Restladung z. B. am nächsten Morgen sein?", "wie wird die Spannung am nächsten Morgen sein?" oder "wie haben sich Kapazität und Leistung im Laufe der Zeit entwickelt?" beantwortet werden. Entsprechende Auswertungen werden als Signal an ein Bordnetz des jeweiligen Kraftfahrzeugs weitergegeben, so dass von einem dort ansässigen Bordnetzsteuergerät weitere Aktionen, wie bspw. Abschalten des Motors bei Stillstand an der Ampel, durchgeführt werden können.

Mit Hilfe eines elektronischen Batteriesensors werden demnach Spannungen und Strom (über einen Shuntwiderstand) und Temperaturen in der Regel permanent gemessen und gespeichert, d. h. auch in Ruhephasen der jeweiligen Batterie. Damit ist nicht nur eine Restladung der Batterie bekannt, sondern aus Erfahrungswerten vergangener Motorstarts auch eine Anforderung an einen Energiespeicher. Auch können derzeitige und frühere Werte verglichen werden, so dass Erkenntnisse über eine Alterung und mögliche Restlebensdauer einer Batterie möglich sind. Durch das Vorsehen eines Batteriesensors ist es möglich, dass das den Batteriesensor umfassende Energiemanagementsystem in kritischen Zonen rechtzeitig vorsieht, nicht unbedingt nötige Funktionen, wie bspw. eine zweite Stufe einer Heckscheibenheizung oder einer Frontscheibe bereits abzuschalten, wenn sich die Batterie einem kritischen Zustand auch nur nähert.

Es ist üblich, dass eine Mechanik eines elektronischen Batteriesensors auf einer Polklemme der Batterie basiert, die einen Shuntwiderstand, ein Massekabelanschluss und eine integrierte Elektronik aufweist. Der Shuntwiderstand stellt dabei üblicherweise eine Messbrücke aus Kupfer/Manganin/Kupfer dar. Auftretende Spannungsschwankungen werden ausgewertet und als Signal an ein jeweiliges Bordnetz im Kraftfahrzeug weitergegeben. Mit diesen Informationen werden dann vom Bordnetzsteuergerät weitere Aktionen, wie bspw. Abschalten des Motors bei Stillstand an der Ampel, durchgeführt.

Bei der sogenannten Kupfer-Inlay-Technik wird ein massives Kupferteil in voller Leiterplattendicke in eine jeweilige Leiterplatte eingepresst und verankert. Dabei dient das Kupfer-Inlay einerseits als Lötfläche für Leistungshalbleiter und andererseits als hochleistungsfähiger Wärmeleitpfad durch die jeweilige Leiterplatte. Von dieser Seite kann die Wärme direkt mittels Wärmeleitkleber an geeignete Wärmesenken abgeführt werden. Dieses Entwärmungskonzept wurde vor allem für eine unmittelbar bauteilbezogene Wärmeableitung durch Kupfer-Inlays in ein jeweiliges Gehäuse bzw. in einen Kühlkörper entwickelt. Alles was mehr als 6 W Verlustleistung aufweist ist ideal als Kupfer-Inlay Partner. In der Fertigung bleibt alles beim Alten und Kupfer-Inlays können mit allen bekannten Leiterplattentechnologien kombiniert werden.

Da ein eingangs erwähnter elektronischer Batteriesensor an einer Batterie anzuordnen ist und dort wünschenswerterweise möglichst platzsparend und unauffällig platziert werden sollte, war es nunmehr eine Aufgabe der vorliegenden Erfindung, einen elektronischen Batteriesensor vorzusehen, der einfach gebaut und platzsparend und dabei auch kostengünstig in einer Polnische einer Kraftfahrzeugbatterie möglichst vollständig integriert werden kann.

### Offenbarung der Erfindung

Vor dem Hintergrund des Standes der Technik und der voranstehend genannten Aufgabe stellt die Erfindung nunmehr einen elektronischen Batteriesensor mit den Merkmalen von Patentanspruch 1, sowie ein Verfahren zur Bereitstellung eines elektronischen Batteriesensors mit den Merkmalen von Patentanspruch 9 bereit.

Erfindungsgemäß wird ein elektronischer Batteriesensor zur Zustandserkennung einer Batterie mit einem Shuntwiderstand und einer Leiterplatte mit einer Messschaltung bereitgestellt. Dabei ist der Shuntwiderstand als Messbrücke aus einer Kombination von mindestens einem ersten und einem zweiten Werkstoff realisiert, und mindestens einer der Werkstoffe liegt als mindestens ein Inlay der Leiterplatte vor.

Gemäß einer Ausführungsform des erfindungsgemäßen elektronischen Batteriesensors stellt der Shuntwiderstand eine Messbrücke aus Kupfer/Widerstandsmaterial/Kupfer dar, weist zwei Anschlüsse auf, und Kupfer oder das Widerstandsmaterial liegt als mindestens ein Inlay der Leiterplatte vor. Als Widerstandsmaterial kann bspw. Manganin oder Isaohm gewählt werden.

Es ist denkbar, dass die Messbrücke aus Kupfer/Widerstandsmaterial/Kupfer vollständig als Inlay in die Leiterplatte integriert ist. Dabei schließt das Inlay zur Ober- bzw. Unterseite der Leiterplatte hin mit Kupfer ab und ist von der Ober- zur Unterseite der Leiterplatte von einer Bohrung durchsetzt. Das bedeutet, dass das vollständig in die Leiterplatte integrierte Inlay quasi als Hülse mit drei Schichten vorliegt, wobei die zur Oberseite der Leiterplatte hinweisende Schicht eine Kupferschicht, die zur Unterseite hinweisende Schicht ebenfalls eine Kupferschicht und mittig eine Schicht aus dem Widerstandsmaterial vorgesehen ist. Die aus diesen drei Schichten zusammengesetzte Hülse weist definitionsgemäß eine in etwa mittige Bohrung auf, durch welche ein Verbindungselement durchgeführt werden kann, auf welches zu beiden Seiten, d. h. an Oberseite und Unterseite der Leiterplatte, ein Kabelschuh bzw. eine Polklemme angebracht werden kann, so dass sowohl die Polklemme als auch der Kabelschuh mit einer jeweiligen Kupferschicht des als Inlay vorliegenden Shuntwiderstands in Kontakt kommt. Um einen elektrischen Kontakt zwischen Kabelschuh und Polklemme über das Verbindungselement zu vermeiden, weist dieses eine entsprechende Isolierung in der Verbindung zwischen Polklemme und Kabelschuh auf. Ferner muss eine Isolierung zwischen Verbindungselement, welches durch die Bohrung des Inlays hindurchgeführt wird, zu dem Inlay selbst, d. h. zu dessen Innenwandung, gewährleistet werden, was ebenfalls durch ein Isoliermaterial erreicht werden kann, welches das Verbindungselement umgibt und zwischen Verbindungselement und Bohrungsinnenwandung des Shuntwiderstands angeordnet ist.

Eine Stärke bzw. Dicke des in die Leiterplatte integrierten Inlays kann variieren, da sich die Stärke bzw. die Dicke über einen gewünschten bzw. benötigten Widerstandswert, eine benötigte Größe des Inlays und das verwendete Widerstandsmaterial bestimmt. Wünscht man bspw. einen Widerstandswert von ca. 50 µΩ, wird für die Widerstandsmaterialschicht der zusammengesetzten Hülse ein Außendurchmesser von 9 mm, ein Innendurchmesser von 6,3 mm und eine Schichtdicke des Widerstandsmaterials von etwa 0,5 mm angesetzt. Das bedeutet, dass das Inlay dünner, genauso dick und/oder dicker als die Leiterplatte sein kann, was im Wesentlichen von dem benötigten Widerstandswert abhängt.

Eine benötigte Form des Inlays als Messbrücke kann sich ebenfalls durch einen entsprechenden Verwendungszweck von einer Standardform eines Inlays unterscheiden. Im Anwendungsfall eines Batteriesensors wird bspw. auf das Inlay noch ein zusätzliches Anzugmoment durch Polklemme und Kabelschuh aufgebracht, so dass ggf. Formen einzusetzen sind, die das Anzugsmoment aufnehmen und eine elektrische Anbindung aufrechterhalten.

Gemäß des erfindungsgemäßen elektronischen Batteriesensors liegt ein Werkstoff nicht als Inlay vor. Der nicht als Inlay vorliegende Werkstoff ist dann als mindestens ein separates Bauteil mit dem als Inlay vorliegenden Werkstoff zur Bereitstellung der Messbrücke verbunden, wie bspw. gelötet, geklebt bzw. gepresst oder geklemmt.

In Ausgestaltung des elektronischen Batteriesensors ist Kupfer an einer ersten Stelle und an einer zweiten Stelle der Leiterplatte als jeweiliges Inlay in die Leiterplatte eingepresst, und das erste Inlay ist mit dem zweiten Inlay über eine Widerstandsmaterialbrücke, bspw. eine Manganinbrücke, verbunden. Die Widerstandsmaterialbrücke, bspw. eine Manganinbrücke, ist dabei als separates Bauteil realisiert und mit dem ersten und dem zweiten Inlay in der Leiterplatte verlötet.

Gemäß einer weiteren Ausführungsform des elektronischen Batteriesensors ist am ersten Kupferinlay der Leiterplatte ein erster Anschluss zum Anschluss eines Kabelschuhs und am zweiten Kupferschuh der Leiterplatte ein zweiter Anschluss zum Anschluss einer Polklemme der Batterie vorgesehen.

Dabei ist es denkbar, dass der erste Anschluss als Durchgangsbohrung im jeweiligen Inlay ausgebildet ist. Durch die Durchgangsbohrung wird dann bspw. eine Schraube durchgeführt, auf welcher ein Kabelschuh oder eine Polklemme aufgesetzt und letztlich mit einer Mutter verschraubt wird. Ferner ist es jedoch auch denkbar, dass der erste Anschluss als Gewindebolzen aus Kupfer ausgebildet ist. Auf den Gewindebolzen ist dann der Kabelschuh bzw. die Polklemme aufzusetzen und mit einer Mutter zu verschrauben. Gleiche Wahlmöglichkeiten gelten für den zweiten Anschluss, wobei erster Anschluss und zweiter Anschluss nicht gleichartig ausgebildet sein müssen. Das bedeutet, dass der erste Anschluss als Bohrung ausgebildet sein kann, während der zweite Anschluss als Gewindebolzen aus Kupfer realisiert ist oder umgekehrt. Allerdings können auch erster Anschluss und zweiter Anschluss gleich, nämlich als Bohrung oder als jeweilige Gewindebolzen aus Kupfer realisiert sein.

Bei dem erfindungsgemäßen elektronischen Batteriesensor muss kein separater Shuntwiderstand mit einer Werkstoffpaarung Kupfer/Manganin/Kupfer bereitgestellt werden, da mindestens einer der Werkstoffe Kupfer oder ein Widerstandsmaterial, wie bspw. Manganin, von der Leiterplatte als Inlay bereitgestellt werden. Eine Messbrücke erfolgt sodann über ein oder zwei Inlays, bspw. Kupferinlays, in der jeweiligen Leiterplatte. Wie bereits voranstehend erwähnt, können der erste Anschluss und der zweite Anschluss frei gewählt werden, um die Polklemme der Batterie bzw. den Kabelschuh zu kontaktieren.

Mit Hilfe des erfindungsgemäßen elektronischen Batteriesensors ist es möglich, dass nur ein Bauteil aus Widerstandsmaterial, wie bspw. aus Manganin, benötigt wird, wobei die Größe des Widerstandsmaterialbauteils, insbesondere des Manganinbauteils, über einen zur Durchführung einer aussagekräftigen Messung benötigten elektrischen Widerstand bestimmt wird. Wie nachfolgend erläutert sind dabei verschiedene Anschlussvarianten möglich.

Die vorliegende Erfindung stellt ferner einen Shuntwiderstand mit zwei Anschlüssen bereit, wobei der Shuntwiderstand als Messbrücke aus einer Kombination von mindestens einem ersten und einem zweiten Werkstoff realisiert ist und wobei mindestens einer der Werkstoffe als mindestens ein Inlay einer Leiterplatte vorliegt.

Der erfindungsgemäß bereitgestellte Shuntwiderstand ist insbesondere in einem erfindungsgemäßen elektronischen Batteriesensor vorzusehen.

Ferner betrifft die vorliegende Erfindung ein Verfahren zur Bereitstellung eines elektronischen Batteriesensors zur Zustandserkennung einer Batterie, bei dem ein Shuntwiderstand mit zwei Anschlüssen und eine Leiterplatte mit einer Messschaltung bereitgestellt werden. Der Shuntwiderstand wird dabei als Messbrücke aus einer Kombination von mindestens einem ersten und einem zweiten Werkstoff realisiert, wobei mindestens einer der Werkstoffe als mindestens ein Inlay der Leiterplatte bereitgestellt wird.

Das vorliegende erfindungsgemäße Verfahren ist insbesondere zur Bereitstellung eines elektronischen erfindungsgemäßen Batteriesensors ausgelegt.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Kurze Beschreibung der Zeichnungen

- Figur 1: zeigt in schematischer Darstellung in Figur 1a eine Schnittansicht und in Figur 1b eine Aufsicht einer Ausführungsform eines erfindungsgemäßen elektronischen Batteriesensors.
- Figur 2: zeigt in den Figuren 2a, 2b, 2c und 2d verschiedene Möglichkeiten vorzusehender Inlays in weiteren Ausführungsformen des erfindungsgemäßen elektronischen Batteriesensors.
- Figur 3: zeigt in den Figuren 3a, 3b und 3c verschiedene Anschlussmöglichkeiten bei einem erfindungsgemäßen elektronischen Batteriesensor.
- Figur 4: zeigt in Schnittansicht eine weitere Ausführungsform eines erfindungsgemäßen elektronischen Batteriesensors.
- Figur 5: zeigt in Figur 5a eine Aufsicht und in Figur 5b eine Schnittansicht bzw. Seitenansicht einer noch weiteren Ausführungsform eines erfindungsgemäßen elektronischen Batteriesensors.
- Figur 6: zeigt in den Figuren 6a bis 6d eine jeweilige Seitenansicht einer weiteren Ausführungsform eines erfindungsgemäßen Batteriesensors.
- Figur 7: zeigt in Aufsicht verschiedene Formen von möglichen Inlays, wie sie in jeweiligen Ausführungsformen eines erfindungsgemäßen Batteriesensors vorgesehen sein können.

### Ausführungsformen der Erfindung

Die Erfindung ist anhand von Ausführungsformen in den Zeichnungen schematisch dargestellt und wird nachfolgend unter Bezugnahme auf die Zeichnungen ausführlich beschrieben.

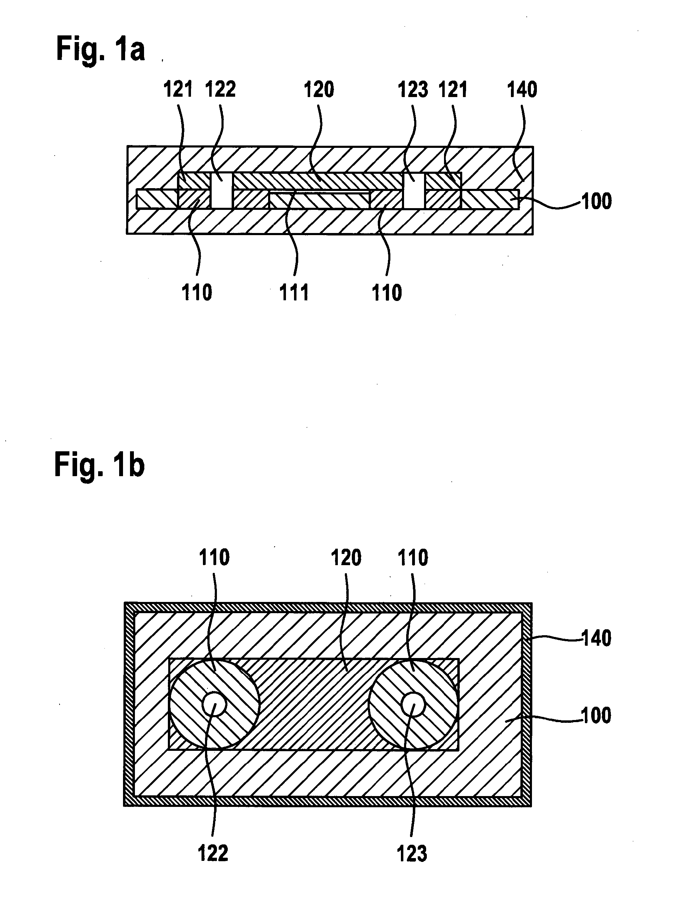

Figur 1a zeigt in Seitenansicht eine Leiterplatte 100 mit zwei Kupferinlays 110, welche voneinander beabstandet in die Leiterplatte 100 eingelassen bzw. eingepresst sind und über eine Widerstandsmaterialbrücke, wie bspw. eine Manganinbrücke 120, als separatem Bauteil oberhalb der Leiterplatte 100 wiederum miteinander verbunden sind. Dadurch wird eine Messbrücke Kupfer/ Widerstandsmaterial /Kupfer realisiert. Die Widerstandsmaterialbrücke, im Folgenden beispielhaft eine Manganinbrücke 120, ist an Lötstellen 121 mit den jeweiligen Kupferinlays 110 verlötet und damit mit diesen in elektrischem Kontakt. Zwischen der Manganinbrücke 120 und der Leiterplatte 100 zwischen den Kupferinlays 110 ist ein Abstand 111 erkennbar, so dass hier kein elektrischer Kontakt zwischen Manganinbrücke 120 und Leiterplatte 100 möglich ist. Sowohl das erste Kupferinlay als auch das zweite Kupferinlay weist einen jeweiligen Anschluss 122 bzw. 123 auf, worüber ein elektrischer Kontakt zu einem Kabelschuh bzw. einer Polklemme der zu prüfenden Batterie ermöglicht wird. In der hier gezeigten Darstellung sind die Anschlüsse 122 und 123 gleichartig ausgeführt, nämlich als Bohrung bzw. Durchgangsbohrung in dem jeweiligen Kupferinlay. In der hier gezeigten Ausführungsform ist die Bohrung, da die Manganinbrücke 120 oberhalb der Kupferinlays 110 aufsitzt und sich über deren gesamten Bereich erstreckt, auch durch die Manganinbrücke 120 hindurchgeführt. In diese Bohrung kann nunmehr zur elektrischen Kontaktierung einer Polklemme bzw. eines Kabelschuhs ein Verbindungselement, bspw. in Form einer Schraube, eingeführt und mittels einer jeweiligen Mutter mit dem Kabelschuh bzw. der Polklemme verschraubt werden.

Der gesamte elektronische Batteriesensor ist in der Regel, wie hier dargestellt, mit einem Moldgehäuse 140 umgeben, welches den Sensor nach außen hin isoliert, mit Ausnahme der Anschlüsse 122 und 123.

Figur 1b zeigt eine Aufsicht auf den in Figur 1a gezeigten Batteriesensor. Dabei sind die zwei Kupferinlays 110 erkennbar, welche kreisförmig ausgebildet sind und in ihrer jeweiligen Mitte eine Ausnehmung bzw. Bohrung 122 bzw. 123 aufweisen. Oberhalb der Kupferinlays 110 und die Kupferinlays 110 verbindend ist einen Manganinbrücke 120 angeordnet, welche über Lötpads 121 mit den Kupferinlays 110 jeweils verlötet ist. Die Durchgangsbohrungen 122 bzw. 123 durchdringen auch die Manganinbrücke 120, um einen elektrischen Kontakt mit einem hier nicht gezeigten Kabelschuh bzw. einer hier nicht gezeigten Polklemme realisieren zu können.

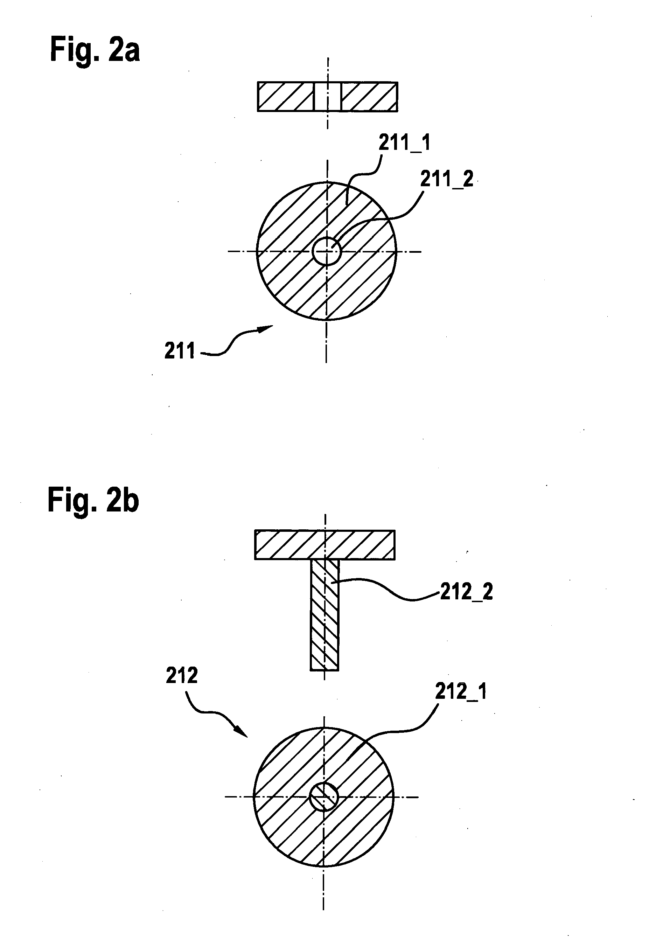

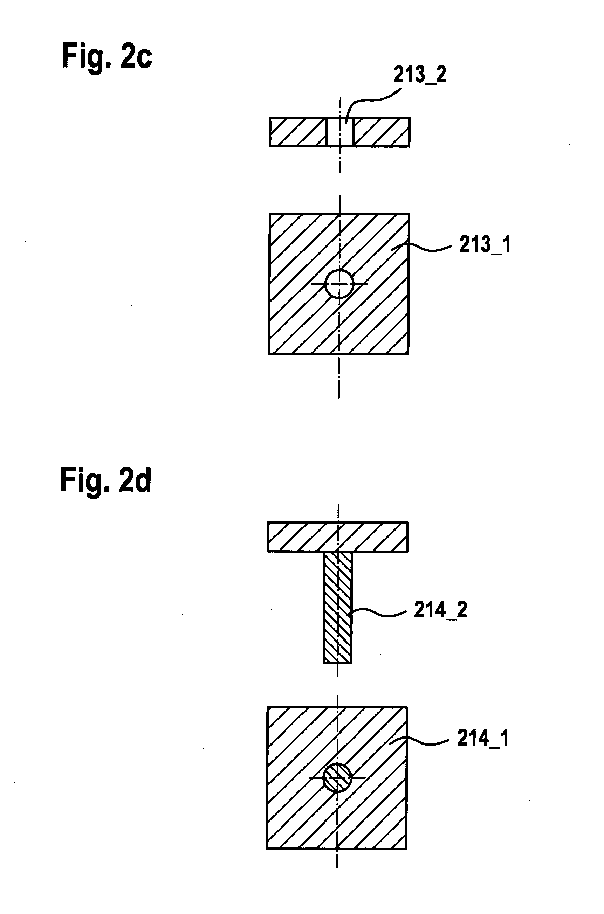

Figur 2 zeigt verschiedene Möglichkeiten der Ausbildung eines jeweiligen Inlays, insbesondere eines Kupferinlays in einer Leiterplatte. In den Figuren 2a, 2b, 2c und 2d ist jeweils eine Seitenansicht sowie eine Aufsicht auf das jeweils dargestellte Inlay gezeigt.

Figur 2a zeigt ein kreis- bzw. ringförmiges Kupferinlay, welches in seiner Mitte eine Bohrung 211_2 aufweist und eine ringförmige Umgebung 211_1 hat. Im oberen Bereich ist eine Seitenansicht und im unteren Bereich eine Aufsicht auf das Kupferinlay 211 dargestellt.

Figur 2b zeigt wiederum ein ringförmiges Kupferinlay 212_1, welches jedoch keine Bohrung aufweist, sondern vielmehr einen Gewindebolzen 212_2, auf welchen eine Mutter aufgesetzt und mit einer Polklemme bzw. einem Kabelschuh verschraubt werden kann. Der Gewindebolzen 212_2 ist insbesondere in der im oberen Bereich von Figur 2b dargestellten Seitenansicht erkennbar.

Figur 2c zeigt ein Inlay 213_1, welches eine quadratische Außenkontur aufweist und in seiner Mitte eine Bohrung 213_2 zeigt, durch welche, ähnlich wie in Figur 2a, eine Kontaktierung mittels einer einzuführenden Schraube und einer Verschraubung mit einer Mutter realisiert werden kann.

Figur 2d zeigt, ähnlich wie Figur 2b, ein Inlay 214_1 mit einem davon abstehenden Gewindebolzen 214_2, wobei jedoch die Außenkontur des hier gezeigten Inlays 214_1 quadratisch ausgebildet ist.

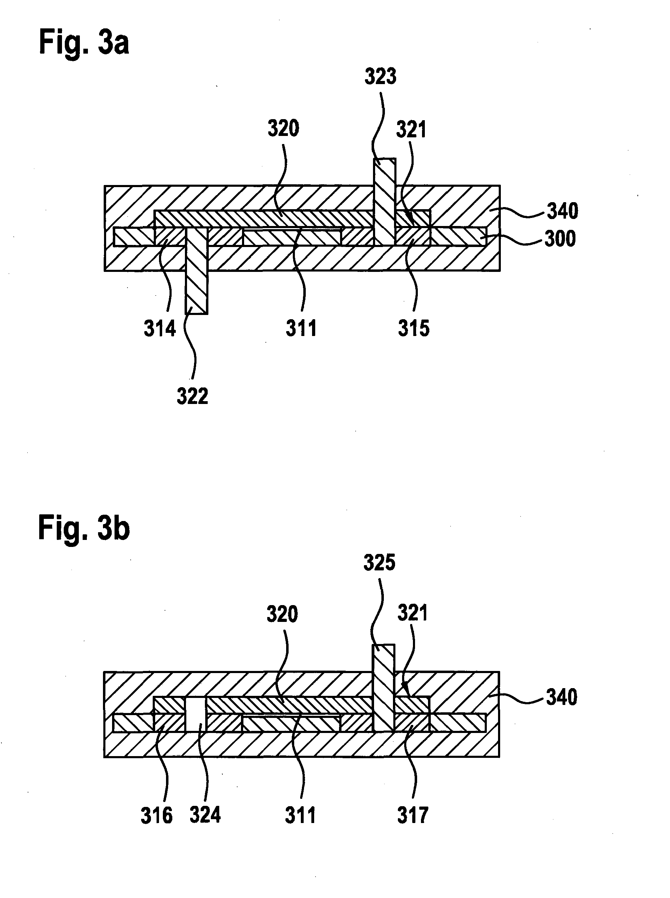

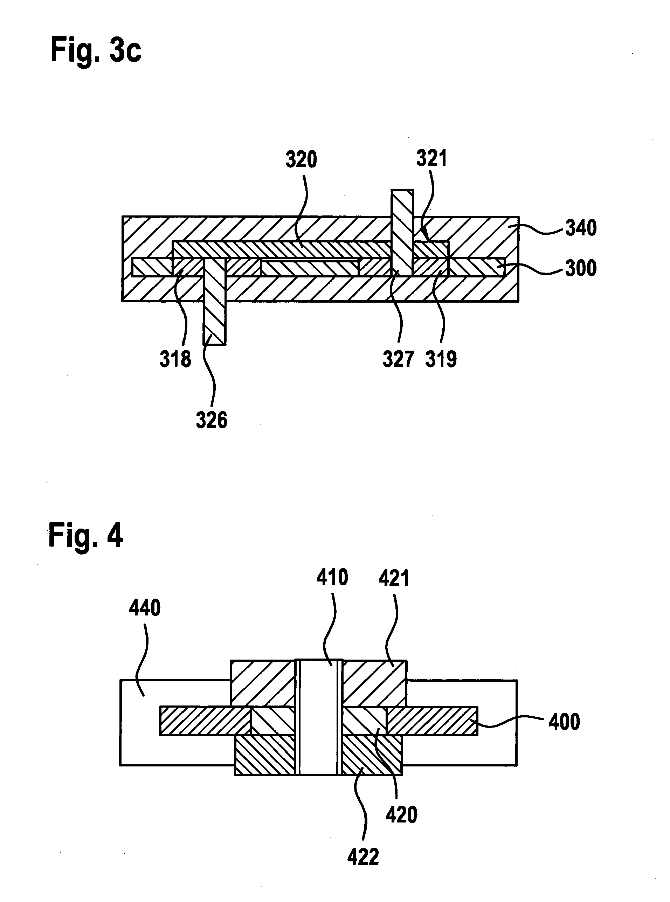

Figur 3 zeigt in Figur 3a eine Seitenansicht einer möglichen Ausführungsform eines weiteren elektronischen Batteriesensors. In der Leiterplatte 300 sind hier zwei Kupferinlays 314 und 315 eingelassen bzw. eingepresst, welche wiederum durch eine Manganinbrücke 320 als Beispiel für eine Widerstandsmaterialbrücke über jeweilige Lötpads 321 miteinander verbunden werden, wobei die Inlays 314 und 315 in der Leiterplatte 300 voneinander beabstandet sind. Die Manganinbrücke 320 ist in dem Bereich zwischen den Inlays 314 und 315 ebenfalls von der Leiterplatte 300 um eine Distanz 311 beabstandet, so dass hier kein elektrischer Kontakt zwischen Manganinbrücke 320 und Leiterplatte 300 möglich ist. Die Anschlüsse 322 und 323 sind hier ähnlich ausgeführt, nämlich durch Gewindebolzen, welche aus der Leiterplatte und aus einem die Leiterplatte umschließenden Gehäuse 340 herausragen, so dass hierüber ein jeweiliger Anschluss einer Polklemme bzw. eines Kabelschuhs möglich ist. Die Gewindebolzen ragen allerdings zu verschiedenen, sich gegenüberliegenden Seiten aus dem Gehäuse 340 heraus, wobei bei Anschluss 323 der Gewindebolzen auch die Manganinbrücke 320 durchdringt. Die hier dargestellten Gewindebolzen 323 bzw. 322 können zum Anschluss an eine Polklemme durch diese hindurch geführt und mittels einer Mutter verschraubt werden, so dass eine elektrische Kontaktierung realisiert wird. Beim Anschluss eines Kabelschuhs ist es denkbar, den Kabelschuh direkt mit einer Mutter auf dem Gewindebolzen zu verschrauben und so einen elektrischen Kontakt herzustellen. Die Kupferinlays 314 und 315 können in der hier gezeigten Darstellung bezüglich ihrer Außenkontur entweder gleichartig ausgeführt sein, wie bspw. als Kreis oder als Quadrat; jedoch ist es auch denkbar, dass sie bezüglich ihrer Außenkontur unterschiedlich ausgeführt sind.

Figur 3b zeigt wiederum die Leiterplatte 300 mit zwei Kupferinlays 316 und 317, welche über eine Manganinbrücke 320 als Beispiel für eine Widerstandsmaterialbrücke miteinander verbunden sind. Die elektrische Verbindung hierbei wird über Lötpads 321 realisiert. Zwischen Manganinbrücke 320 und Leiterplatte 300 besteht im Zwischenraum zwischen den Kupferinlays 316 und 317 wieder ein Abstand 311, so dass hier kein elektrischer Kontakt möglich ist. Wiederum ist der elektronische Batteriesensor in einem Moldgehäuse 340 eingebettet, so dass er nach außen hin isoliert ist. Die Anschlüsse 324, 325 sind hier gegenüber Figur 3 etwas unterschiedlich ausgeführt. Das Kupferinlay 317 weist wiederum einen Gewindebolzen auf, welcher aus dem Moldgehäuse 340 herausragt und einen Anschluss einer Polklemme bzw. eines Kabelschuhs ermöglicht. Das Kupferinlay 316 verfügt, im Gegensatz zum Anschluss 314 in Figur 3a, nicht über einen Gewindebolzen, sondern über eine Bohrung, worüber ebenfalls ein elektrischer Kontakt mit einem Kabelschuh bzw. einer Polklemme realisiert werden kann, nämlich durch Einführen eines Verbindungselements, bspw. einer Schraube, eines Aufsetzens einer Polklemme auf das Verbindungselement bzw. eines Einklemmens eines Kabelschuhs und einer entsprechenden Verschraubung mittels einer Mutter. Die äußere Kontur der Kupferinlays 316, 317 kann hier wiederum gleichartig oder auch unterschiedlich ausgeführt sein. So kann Kupferinlay 316 bezüglich seiner Außenkontur quadratisch, rechteckig oder kreisförmig ausgeführt sein, ähnlich wie dies in Figur 2a bzw. Figur 2c gezeigt ist, während Kupferinlay 317 bezüglich seiner Außenkontur ebenfalls quadratisch, rechteckig oder kreisförmig ausgebildet sein kann, ähnlich wie dies in Figur 2b bzw. Figur 2d gezeigt ist.

Figur 3c zeigt eine noch weitere mögliche Ausführungsform der Anschlüsse zum Anschluss eines Kabelschuhs bzw. einer Polklemme. Wiederum ist hier eine Leiterplatte 300 gezeigt mit zwei Kupferinlays 318 und 319. Die Kupferinlays sind wiederum verbunden über eine Manganinbrücke 320 als Beispiel für eine Widerstandsmaterialbrücke, welche in einem gelöteten Bereich 321 mit den jeweiligen Kupferinlays verlötet ist. Die Leiterplatte 300 samt Inlays und Manganinbrücke ist von einem Gehäuse 340 umgeben, um nach Außen hin isoliert zu sein. Das Kupferinlay 318 ermöglicht einen Anschluss über einen Gewindebolzen, welcher aus dem Gehäuse 340 herausragt. Das Kupferinlay 319 weist eine Bohrung auf, welche ebenfalls, wie voranstehend bereits beschrieben, eine Kontaktierung mit einer Polklemme bzw. einem Kabelschuh ermöglicht. Im Falle, dass eine Bohrung vorgesehen ist, ist es jeweils auch erforderlich, dass die darüber liegende Manganinbrücke 320 ebenfalls von dieser Bohrung durchsetzt wird, um einen Anschluss hierüber zu ermöglichen.

Figur 4 zeigt eine weitere mögliche Ausführungsform eines erfindungsgemäßen elektronischen Batteriesensors. Die Leiterplatte 400 umfasst hier ein Widerstandsmaterialinlay, wie bspw. Manganininlay 420. Auf beiden Seiten der Leiterplatte 400, d. h. oberhalb und unterhalb der Leiterplatte 400, ist jeweils eine Kupferhülse 421 bzw. 422 angeordnet, welche jeweils mit der Leiterplatte und insbesondere mit dem Manganininlay verbunden sind. Die Kupferhülse 421 und die Kupferhülse 422 ragen zu verschiedenen sich gegenüberliegenden Seiten der Leiterplatte aus einem Gehäuse 440 heraus, um zum Anschluss einer Polklemme bzw. eines Kabelschuhs eine jeweilige Auflagefläche bieten zu können. Mittig ist ein Isolierteil 410 vorgesehen, welches durch eine Bohrung durchgeführt ist und sowohl die Kupferhülse 421, das Manganininlay 420 als auch die Kupferhülse 422 durchdringt.

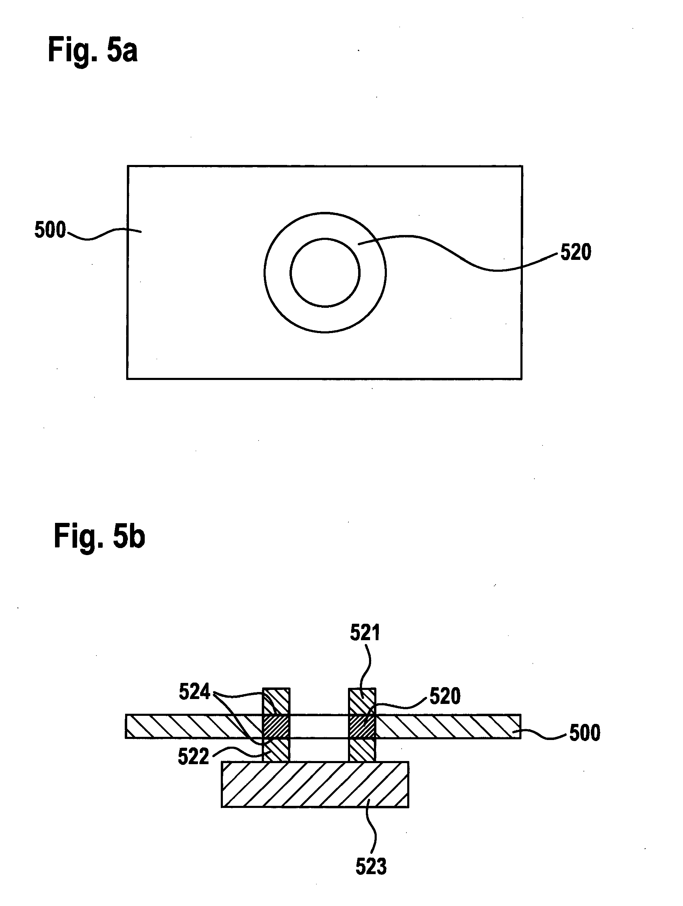

Figur 5 zeigt eine noch weitere mögliche Ausführungsform eines erfindungsgemäßen elektronischen Batteriesensors. Figur 5a zeigt eine Aufsicht und Figur 5b zeigt eine Seitenansicht des elektronischen Batteriesensors. Die Leiterplatte 500 umfasst als Inlay einen Widerstandsmaterialringring, wie bspw. wie einen Manganinring 520, auf welchem zu beiden Seiten der Leiterplatte ein jeweiliger Kupferring 521 bzw. 522 angebracht, wie bspw. aufgelötet oder geklebt ist. Der Kupferring 522 bietet eine Auflagefläche für eine Polklemme 523, während der Kupferring 521 eine Möglichkeit zum Anschluss eines Kabelschuhs bereitstellt. Die Kupferringe 521 bzw. 522 sind jeweils in gelöteten Bereichen 524 jeweilig mit der als Messbrücke fungierenden Manganinhülse bzw. dem Manganininlay 520 verlötet.

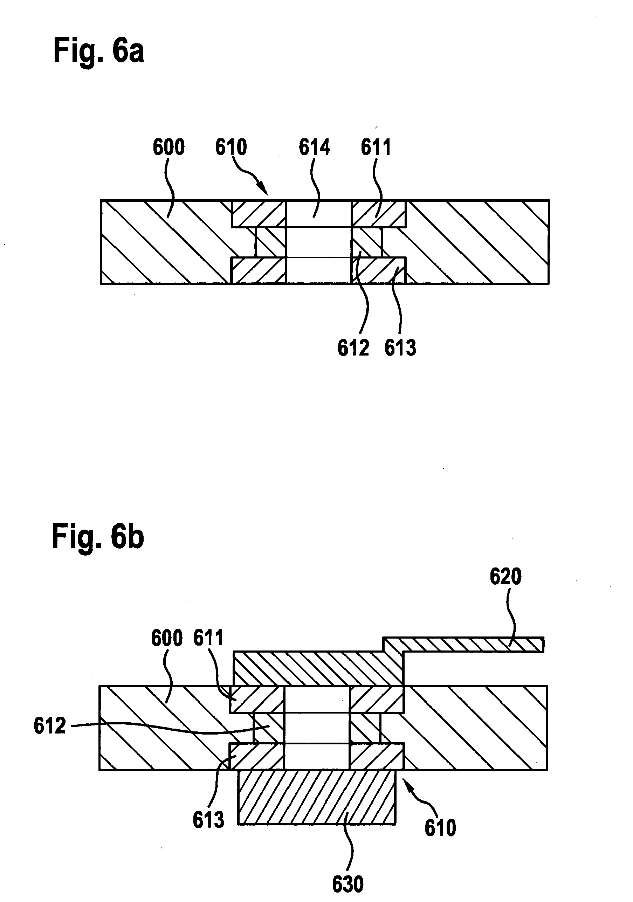

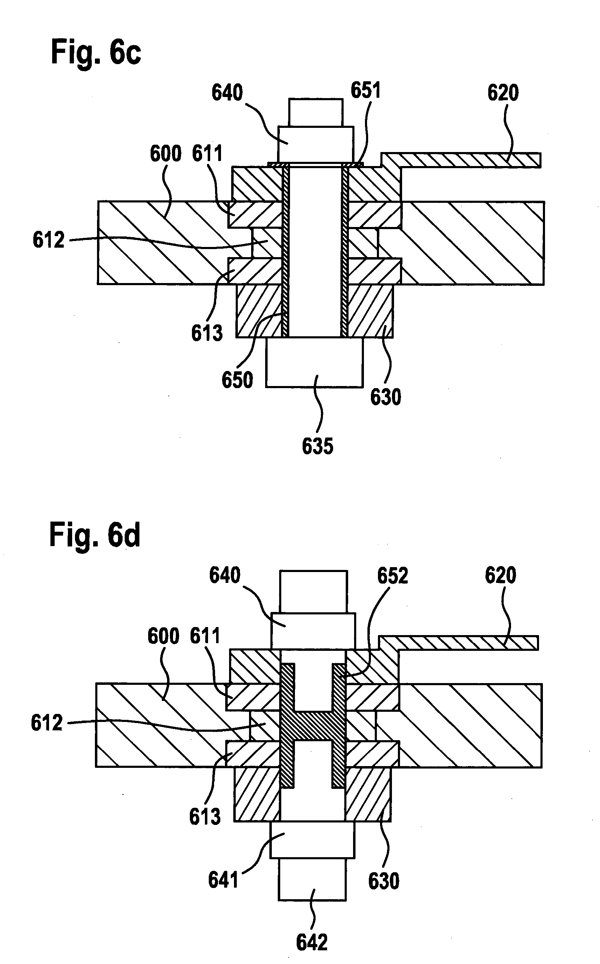

Figur 6 zeigt in schematischer Darstellung eine Seitenansicht einer weiteren Ausführungsform eines erfindungsgemäßen elektronischen Batteriesensors.

Gezeigt ist eine Leiterplatte 600 mit einem Shuntwiderstand 610. Der Shuntwiderstand 610 ist hier vollständig als Inlay in die Leiterplatte 600 eingelassen. Der Shuntwiderstand 610 setzt sich zusammen aus einem ersten Kupferinlay 611, einem zweiten Kupferinlay 613 und einem dazwischenliegenden Inlay eines Widerstandmaterials 612. Das sich so zusammensetzende Inlay aus Kupfer, Widerstandsmaterial, Kupfer bildet in Kombination eine Messbrücke und schließt in der hier gezeigten Ausführungsform sowohl an der Ober- wie auch an der Unterseite der Leiterplatte 600 mit dieser bündig ab. Auf die Kupferschicht bzw. das Kupferinlay 611 kann ein Kabelschuh kontaktiert werden, während auf die Kupferschicht bzw. das Kupferinlay 613 die Kontaktierung einer Polklemme vorgenommen werden kann. Durch die dazwischenliegende Schicht 612 eines Widerstandsmaterials kann die Messbrücke in der Leiterplatte 600 realisiert werden. Bei dem Widerstandsmaterial kann es sich bspw. um Manganin oder um Isaohm handeln. Im Gegensatz zu der hier dargestellten Ausführungsform kann das in die Leiterplatte 600 integrierte Inlay auch dünner oder dicker als die Leiterplatte 600 sein, was von einem im konkreten Anwendungsfall benötigten Widerstandswert abhängt.

Durch die spezifische Ausgestaltung des erfindungsgemäßen elektronischen Batteriesensors wird ermöglicht, dass kein separater Shuntwiderstand mit einer Werkstoffpaarung Kupfer/Widerstandsmaterial/Kupfer benötigt wird, da sowohl das Kupfer wie auch das Widerstandsmaterial schon bei Herstellung der Leiterplatte 600 als Inlay bei der Fertigung mit integriert werden kann. Bei der Ausgestaltung, wie sie in Figur 6 dargelegt ist, ist die Anordnung der Polklemme und des Kabelschuhs auf der Leiterplatte 600, d. h. auf der Ober- bzw. Unterseite der Leiterplatte frei wählbar, da der Shuntwiderstand 610 als Inlay in der Leiterplatte 600 realisiert auf beiden Seiten, d. h. auf Ober- und Unterseite der Leiterplatte 600 quasi mit Kupfer ummantelt ist.

Das dargestellte, zusammengesetzte Inlay ist mittig von einer Bohrung 614 durchsetzt, durch welche zum Anschrauben der Polklemme bzw. des Kabelschuhs ein Verbindungselement, wie bspw. ein Gewindebolzen zu führen ist.

Figur 6b zeigt die in Figur 6a gezeigte Ausführungsform eines elektronischen Batteriesensors mit angeschraubtem Kabelschuh 620 und befestigter Polklemme 630. In die Leiterplatte 600 ist vollständig ein als Messbrücke ausgestalteter Shuntwiderstand 610 integriert, wobei die Kupferschicht 611 und die Kupferschicht 613 den Shuntwiderstand nach außen hin bzw. zur Ober- bzw. Unterseite der Leiterplatte hin abschließen. Zwischen dem Kupferinlay 611 und dem Kupferinlay 613 ist eine Schicht eines Widerstandsmaterials 612 zur Realisierung einer Messbrücke angeordnet. Wie bereits voranstehend erwähnt ist bei dieser Ausgestaltung des erfindungsgemäßen Batteriesensors die Anordnung der Polklemme 630 und des Kabelschuhs 620 auf der Leiterplatte 600, d. h. auf Ober- bzw. Unterseite frei wählbar, da das Inlay bzw. der Shuntwiderstand 610 auf beiden Seiten, d. h. auf Ober- und Unterseite der Leiterplatte mit Kupfer 611 bzw. 613 ummantelt ist.

Figur 6c zeigt nun die Ausführungsform des elektronischen Batteriesensors, wie es bereits in den Figuren 6a und 6b erläutert ist, wobei hier allerdings die Polklemme 630 und der Kabelschuh 620 bereits verschraubt sind. Dazu wird durch die vorgesehene Bohrung 614 ein Gewindebolzen 635 durchgeführt und mit einer Mutter 640 verschraubt. Um den Shuntwiderstand 610 gegen das Verbindungselement bspw. den Schaubbolzen 635 isolieren zu können, ist zwischen Schraubbolzen 635 und Shuntwiderstand 610, Kabelschuh 620 sowie Polklemme 630 ein Isoliermaterial 650 vorgesehen, so dass hier kein jeweiliger elektrischer Kontakt hergestellt werden kann. Durch eine weitere Unterlegscheibe aus isolierendem Material 651 wird ferner gewährleistet, dass auch kein elektrischer Kontakt zwischen Polklemme 630 und Kabelschuh 620 durch das Verbindungselement 635 realisiert wird.

Alternativ dazu kann, wie in Figur 6d dargestellt, eine Isolierung auch dadurch erzielt werden, dass ein aus zwei Teilelementen bestehendes Verbindungselement 642 vorgesehen ist. Dabei sind beide Teilelemente ohne Kopf vorgesehen und werden an einem ihrer jeweiligen Enden in die Bohrung des Shuntwiderstands 610 eingeführt, wobei in die Bohrung bereits ein Isolierelement 652 eingesetzt ist, welches nicht nur entlang der den Shuntwiderstand 610 durchsetzenden Bohrung eine Isolation gegenüber der Bohrungswand, d. h. gegenüber dem Shuntwiderstand 610 bzw. dem Kupferinlay 611, dem Kupferinlay 613 und der Widerstandsmaterialschicht 612, sondern auch eine Isolationsschicht im Bereich zwischen zu kontaktierendem Kabelschuh 620 und zu kontaktierender Polklemme 630 vorsieht, so dass auch zwischen Kabelschuh 620 und Polklemme 630 kein elektrischer Kontakt hergestellt werden kann. Die zwei Teilelemente des Verbindungselements 642 werden von Ober- bzw. Unterseite der Leiterplatte in die Bohrung des Shuntwiderstands 610 eingeführt, so dass die jeweiligen eingeführten Enden der zwei Teilelemente innerhalb der Bohrung an das Isolierelement 652 bzw. dessen quer zur Bohrung verlaufende Isolationsschicht anstoßen bzw. an dieser zum Liegen kommen. Auf die jeweiligen anderen Enden der Teilelemente des Verbindungselements 642 werden dann zur Fixierung jeweilige Muttern 640, 641 aufgeschraubt. Es ist auch denkbar, dass die zwei Teilelemente des Verbindungselements 642 an einem ihrer jeweiligen Enden eine Isolationsschicht aufweisen und mit diesem jeweiligen Ende in die Bohrung des Shuntwiderstands 614 eingeführt werden, so dass die jeweiligen, eine Isolierungsschicht aufweisenden Enden der zwei Teilelemente des Verbindungselements 642 innerhalb der Bohrung aneinanderstoßen bzw. aneinander zum Liegen kommen. Das bedeutet, dass zum einen das Isolierelement 652 einstückig gefertigt sein kann und in die Bohrung eingeführt sein kann. Alternativ dazu kann auch vorgesehen sein, dass die Teilelemente des Verbindungselements 642 mit einer jeweiligen Isolierschicht an einem ihrer jeweiligen Enden versehen sind, so dass hierüber eine Isolation gegenüber dem Shuntwiderstand innerhalb der Bohrung realisiert wird. Es ist auch denkbar, dass das Isolierelement 652 bereits vor Einführen in die Bohrung mit dem Verbindungselement 642 bzw. dessen zwei Teilelementen verbunden, bspw. vergossen, ist.

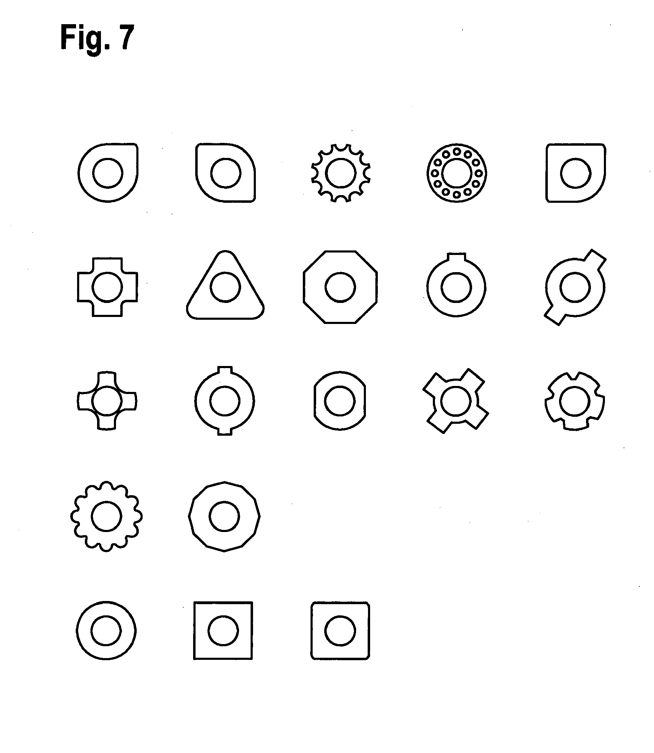

Figur 7 zeigt in fünf Zeilen verschiedene Ausführungsformen von in eine Leiterplatte des elektronischen Batteriesensors einzulassenden Inlays, wobei hier im unteren Bereich, d. h. in Zeile 5 von Figur 7, sogenannte Standardformen wie rund, rechteckig und quadratisch gezeigt sind. Allerdings sind auch Sonderformen, wie in den oberen vier Zeilen von Figur 7 gezeigt, für ein Anschrauben von Kabelschuh bzw. Polklemme an eine entsprechende Leiterplatte möglich. Die hier gezeigten Formen der Inlays zeigen alle eine Aufsicht, wobei die Inlays, die voranstehend erläutert sind, in der Regel aus drei Schichten bestehen, nämlich Kupfer, Widerstandsmaterial, Kupfer und vollständig als Inlay in die jeweilige Leiterplatte integriert sind und dadurch eine Messbrücke realisieren.

Im Anwendungsfall eines Batteriesensors wird auf das Inlay noch ein zusätzliches Anzugsmoment durch Polklemme/Kabelschuh aufgebracht. Somit ist es denkbar, dass eine der in den Zeilen 1 bis 4 gezeigten Sonderformen für das Inlay besser geeignet ist, das Anzugsmoment aufzunehmen und die elektrische Anbindung aufrecht zu erhalten als eine der Standardformen aus Zeile 5.

## Patentansprüche

1. Elektronischer Batteriesensor zur Zustandserkennung einer Batterie mit einem Shuntwiderstand und einer Leiterplatte (100, 300, 400, 500) mit einer Messschaltung, wobei der Shuntwiderstand als Messbrücke aus einer Kombination von mindestens einem ersten und einem zweiten Werkstoff realisiert ist und wobei mindestens einer der Werkstoffe als mindestens ein Inlay der Leiterplatte (100, 300, 400, 500) vorliegt, **dadurch gekennzeichnet, dass** ein nicht als Inlay vorliegender Werkstoff von dem mindestens einen ersten und einen zweiten Werkstoff als mindestens ein separates Bauteil (120, 320, 421, 422, 521, 522) mit dem als Inlay vorliegenden Werkstoff zur Bereitstellung der Messbrücke verbunden ist.

2. Elektronischer Batteriesensor nach Anspruch 1, bei dem der Shuntwiderstand eine Messbrücke aus Kupfer/ Widerstandsmaterial/Kupfer darstellt, zwei Anschlüsse (122, 123, 322, 323) aufweist und Kupfer und/oder das Widerstandsmaterial als das mindestens eine Inlay der Leiterplatte (100, 300, 400, 500) vorliegt.

3. Elektronischer Batteriesensor nach Anspruch 2, bei dem die Messbrücke aus Kupfer/Widerstandsmaterial/Kupfer vollständig als Inlay (610) in die Leiterplatte (600) integriert ist.

4. Elektronischer Batteriesensor nach Anspruch 3, bei dem das Inlay (610) zur Ober- bzw. Unterseite der Leiterplatte (600) hin mit Kupfer abschließt und von der Ober- zur Unterseite der Leiterplatte von einer Bohrung (614) durchsetzt ist.

5. Elektronischer Batteriesensor nach Anspruch 1 oder 2, bei dem Kupfer an einer ersten Stelle und an einer zweiten Stelle der Leiterplatte als jeweiliges Inlay vorliegt und das erste Inlay (110, 314, 316, 318) mit dem zweiten Inlay (110, 315, 317, 319) über eine Widerstandsmaterialbrücke, insbesondere eine Manganinbrücke (120, 320), welche mit dem ersten und dem zweiten Inlay verbunden ist, verbunden sind.

6. Elektronischer Batteriesensor nach Anspruch 5, bei dem am ersten Inlay (110, 314, 316, 318) ein erster Anschluss (122, 322, 324, 326) zum Anschluss eines Kabelschuhs und am zweiten Inlay (110, 315, 317, 319) ein zweiter Anschluss (123, 323, 325, 327) zum Anschluss einer Polklemme der Batterie vorgesehen sind.

7. Elektronischer Batteriesensor nach Anspruch 6, bei dem der erste Anschluss (122, 322, 324, 326) und der zweite Anschluss (123, 323, 325, 327) jeweils wahlweise als Bohrung im jeweiligen Inlay oder als Gewindebolzen aus Kupfer ausgebildet sind.

8. Shuntwiderstand mit zwei Anschlüssen, wobei der Shuntwiderstand als Messbrücke aus einer Kombination von mindestens einem ersten und einem zweiten Werkstoff realisiert ist und wobei mindestens einer der Werkstoffe als mindestens ein Inlay einer Leiterplatte vorliegt, wobei der Shuntwiderstand in einem elektronischen Batteriesensor nach einem der Ansprüche 1 bis 7 vorgesehen ist.

9. Verfahren zur Bereitstellung eines elektronischen Batteriesensors zur Zustandserkennung einer Batterie, bei dem ein Shuntwiderstand mit zwei Anschlüssen und eine Leiterplatte mit einer Messschaltung bereitgestellt werden, wobei der Shuntwiderstand als Messbrücke aus einer Kombination von mindestens einem ersten und einem zweiten Werkstoff realisiert wird und wobei mindestens einer der Werkstoffe als mindestens ein Inlay der Leiterplatte bereit gestellt wird, **dadurch gekennzeichnet, dass** ein nicht als Inlay vorliegender Werkstoff von dem mindestens einen ersten und einen zweiten Werkstoff als mindestens ein separates Bauteil (120, 320, 421, 422, 521, 522) mit dem als Inlay vorliegenden Werkstoff zur Bereitstellung der Messbrücke verbunden wird.

10. Verfahren zur Bereitstellung eines elektronischen Batteriesensors nach einem der Ansprüche 1 bis 7.

## Claims

1. Electronic battery sensor for detecting the state of a battery, having a shunt resistor and a printed circuit board (100, 300, 400, 500) with a measurement circuit, wherein the shunt resistor is realized as a measurement bridge comprising a combination of at least one first and one second material, and wherein at least one of the materials is provided as at least one inlay of the printed circuit board (100, 300, 400, 500), **characterized in that** a material which is not provided as an inlay is connected to the material which is provided as an inlay by the at least one first and one second material as at least one separate component (120, 320, 421, 422, 521, 522) in order to provide the measurement bridge.

2. Electronic battery sensor according to Claim 1, in which the shunt resistor constitutes a measurement bridge comprising copper/resistance material/copper, has two connections (122, 123, 322, 323), and copper and/or the resistance material are provided as the at least one inlay of the printed circuit board (100, 300, 400, 500).

3. Electronic battery sensor according to Claim 2, in which the measurement bridge comprising copper/resistance material/copper is fully integrated into the printed circuit board (600) as an inlay (610).

4. Electronic battery sensor according to Claim 3, in which the inlay (610) ends with copper in the direction of the top face and bottom face of the printed circuit board (600), and a bore (614) passes through the said inlay from the top face to the bottom face of the printed circuit board.

5. Electronic battery sensor according to Claim 1 or 2, in which copper is provided as the respective inlay at a first point and at a second point of the printed circuit board, and the first inlay (110, 314, 316, 318) is connected to the second inlay (110, 315, 317, 319) by means of a resistance material bridge, in particular a manganin bridge (120, 320) which is connected to the first and the second inlay.

6. Electronic battery sensor according to Claim 5, in which a first connection (122, 322, 324, 326) for connecting a cable shoe is provided on the first inlay (110, 314, 316, 318), and a second connection (123, 323, 325, 327) for connecting a pole terminal of the battery is provided on the second inlay (110, 315, 317, 319).

7. Electronic battery sensor according to Claim 6, in which the first connection (122, 322, 324, 326) and the second connection (123, 323, 325, 327) are each selectively formed as a bore in the respective inlay or as a threaded bolt comprising copper.

8. Shunt resistor having two connections, wherein the shunt resistor is realized as a measurement bridge comprising a combination of at least a first and a second material, and wherein at least one of the materials is provided as at least one inlay of a printed circuit board, wherein the shunt resistor is provided in an electronic battery sensor according to one of Claims 1 to 7.

9. Method for providing an electronic battery sensor for detecting the state of a battery, in which a shunt resistor having two connections, and a printed circuit board having a measurement circuit are provided, wherein the shunt resistor is realized as a measurement bridge comprising a combination of at least one first and one second material, and wherein at least one of the materials is provided as at least one inlay of the printed circuit board, **characterized in that** a material which is not provided as an inlay is connected to the material which is provided as an inlay by the at least one first and one second material as at least one separate component (120, 320, 421, 422, 521, 522) in order to provide the measurement bridge.

10. Method for providing an electronic battery sensor according to one of Claims 1 to 7.

## Revendications

1. Capteur électronique de batterie destiné à détecter l'état d'une batterie, présentant une résistance de shunt et une carte de circuit (100, 300, 400, 500) dotée d'un circuit de mesure,
la résistance de shunt étant réalisée sous la forme d'un pont de mesure constitué d'une combinaison d'au moins un premier et d'un deuxième matériau,
au moins l'un des matériaux présentant la forme d'au moins une garniture de la carte de circuit (100, 300, 400, 500),
**caractérisé en ce que**
un matériau non présent comme garniture et faisant partie du ou des premiers et deuxièmes matériaux étant configuré comme au moins un composant distinct (120, 320, 421, 422, 521, 522) relié au matériau présent sous la forme d'une garniture pour réaliser le pont de mesure.

2. Capteur électronique de batterie selon la revendication 1, dans lequel la résistance de shunt constitue un pont de mesure en cuivre/matériau de résistance/cuivre, présente deux bornes de raccordement (122, 123, 322, 323) et du cuivre et/ou en ce que le matériau de résistance présente la forme d'au moins une garniture de la carte de circuit (100, 300, 400, 500).

3. Capteur électronique de batterie selon la revendication 2, dans lequel le pont de mesure présentant la forme de cuivre/matériau de résistance/cuivre est intégré entièrement comme garniture (610) dans la carte de circuit (600).

4. Capteur électronique de batterie selon la revendication 3, dans lequel la garniture (610) ferme la face supérieure ou la face inférieure de la carte de circuit (600) par du cuivre et traverse la carte de circuit de la face supérieure à la face inférieure par un alésage (614).

5. Capteur électronique de batterie selon les revendications 1 ou 2, dans lequel le cuivre est prévu en un premier emplacement et en un deuxième emplacement de la carte de circuit, chaque fois comme garniture, la première garniture (110, 314, 316, 318) étant raccordée à la deuxième garniture (110, 315, 317, 319) par l'intermédiaire d'un pont en matériau de résistance, en particulier un pont de manganine (120, 320), raccordé à la première et à la deuxième garniture.

6. Capteur électronique de batterie selon la revendication 5, dans lequel une première borne de raccordement (122, 322, 324, 326) est prévue sur la première garniture (110, 314, 316, 318) pour le raccordement d'un sabot de câble et une deuxième borne de raccordement (123, 323, 325, 327) est prévue sur la deuxième garniture (110, 315, 317, 319) pour raccorder une borne polaire de la batterie.

7. Capteur électronique de batterie selon la revendication 6, dans lequel la première borne de raccordement (122, 322, 324, 326) et la deuxième borne de raccordement (123, 323, 325, 327) sont toutes deux configurées sélectivement comme alésage dans la garniture concernée ou comme goujon fileté en cuivre.

8. Résistance de Shunt dotée de deux bornes de raccordement, la résistance de shunt étant configurée comme pont de mesure constitué d'une combinaison d'au moins un premier et un deuxième matériau, au moins l'un des matériaux présentant la forme d'au moins une garniture d'une carte de circuit, la résistance de shunt étant prévue dans un capteur électronique de batterie selon l'une des revendications 1 à 7.

9. Procédé de préparation d'un capteur électronique de batterie destiné à détecter l'état d'une batterie,
dans lequel une résistance de shunt présentant deux bornes de raccordement et une carte de circuit dotée d'un circuit de mesure sont préparées,
la résistance de shunt étant réalisée sous la forme d'un pont de mesure constitué d'une combinaison d'au moins un premier et un deuxième matériau,
au moins l'un des matériaux étant préparé sous la forme d'au moins une garniture de la carte de circuit, **caractérisé en ce que**
un matériau ne présentant pas la forme d'une garniture et sélectionné parmi le ou les premiers et deuxièmes matériaux est raccordé comme au moins un composant séparé (120, 320, 421, 422, 521, 522) au matériau présentant la forme d'une garniture pour réaliser le pont de mesure.

10. Procédé de préparation d'un capteur électronique de batterie selon l'une des revendications 1 à 7.
